# EUROPEAN PATENT APPLICATION

(11) **EP 4 788 115 A1**
(43) Date of publication of application: **05.08.2026**
(21) Application number: 25827311.9
(22) Date of filing: 12.06.2025
(51) Int. Cl.: H10P 72/76, H01J 37/32, C04B 41/87, C04B 41/50, C04B 35/10

(54) **CERAMIC SUSCEPTOR INCLUDING CORE/SHELL STRUCTURED MATERIAL AS COATING LAYER**

(30) Priority: 27.06.2024 KR 20240084433
(71) Applicant: KSM Component Co., Ltd., Haseong-myeon Gimpso-si, Gyeonggi-do 10011 (KR)
(72) Inventor: KIM, Yun Ho, Gimpo-si, Gyeonggi-do 10011 (KR); KIM, Joo Hwan, Gimpo-si, Gyeonggi-do 10011 (KR); PARK, Hwan Young, Gimpo-si, Gyeonggi-do 10011 (KR); KIM, Bo Sung, Gimpo-si, Gyeonggi-do 10011 (KR); LEE, Hyun Taek, Gimpo-si, Gyeonggi-do 10011 (KR)
(74) Representative: dompatent
(86) International application number: PCT/KR2025/008062
(87) International publication number: WO 2026/005346

(57) **Abstract**

Disclosed is a ceramic susceptor including a core/shell structure material as a coating layer, which has improved volume resistivity and thermal conductivity as well as plasma resistance, durability, and particle resistance by coating a ceramic sintered body base material having excellent volume resistivity at high temperature and thermal conductivity at room temperature with a core/shell structure material including a material, which has various physical property advantages such as plasma resistance and durability and is similar or identical to the base material. The ceramic susceptor includes a ceramic plate layer; and a coating layer positioned on the ceramic plate layer and formed by sintering a core/shell structure material, wherein the ceramic plate layer includes alumina (Al₂O₃) and aluminum nitride (AlN) and does not include a secondary phase of an aluminum oxynitride (AlON) phase, and the coating layer has a structure in which particle phases forming a shell form a continuous phase along the grain boundary of core particle phases.

## Description

### [Technical Field]

The present application claims the benefit of priority to Korean Patent Application No. 10-2024-0084433 filed on June 27, 2024, the entire contents of which are incorporated as part of this specification.

The present invention relates to a ceramic susceptor including a core/shell structure material as a coating layer, and more particularly, to a ceramic susceptor including a core/shell structure material as a coating layer, which has improved volume resistivity and thermal conductivity as well as plasma resistance, durability, and particle resistance by coating a ceramic sintered body base material having excellent volume resistivity at high temperature and thermal conductivity at room temperature with a core/shell structure material including a material, which has various physical property advantages such as plasma resistance and durability and is similar or identical to the base material.

### [Background Art]

As recent semiconductor processes have evolved toward miniaturization and high integration of processes to improve yields, as well as toward larger diameter equipment, the use of high-power plasma is inevitable, and the process in a harsh high-temperature environment is being performed. In the field of processes for etching semiconductor devices or implementing other ultra-fine shapes, vacuum plasma equipment using high-temperature plasma is widely used. This vacuum plasma equipment includes plasma-enhanced chemical vapor deposition (PECVD) equipment, which uses plasma to form deposition films on substrates using chemical vapor deposition, sputtering equipment, which forms deposition films physically, and dry etching equipment for etching substrates or materials coated on substrates into specific patterns.

The high-temperature plasma generated within the vacuum plasma equipment inevitably damages the chamber and the components provided within the chamber. Furthermore, certain elements and contaminants are likely to be generated from the surfaces of the chamber and the components within the chamber, potentially contaminating the interior of the chamber. In particular, the plasma etching equipment injects reactive gases such as F and Cl under a plasma atmosphere, exposing the inner walls of the chamber and the components within the chamber to a highly corrosive environment. Typically, this corrosion primarily causes chemical and physical damage to the chamber and the components provided within the chamber, and secondarily generates contaminants and particles, which increases the defect rate and lowers the quality of products prepared through the process inside the chamber.

In addition, when the chamber and the components provided inside the chamber are damaged, additional costs are incurred because some of the damaged equipment should be replaced, cleaned, or repaired, and the process line should be stopped for this purpose, which also increases the process time required to prepare the product. For this reason, the metal susceptors installed inside the existing chamber are being replaced with ceramic susceptors, and examples of such ceramic susceptors include sintered aluminum nitride (AlN) or sintered alumina (Al₂O₃), which have excellent thermal conductivity. These ceramic susceptors are primarily used in heaters and electrostatic chucks for semiconductor manufacturing processes.

Aluminum nitride is stable at high temperatures and possesses physical properties having excellent electrical insulation and thermal conductivity. Furthermore, because the aluminum nitride has a coefficient of thermal expansion similar to that of silicon, the aluminum nitride is primarily used in semiconductor manufacturing equipment that requires high electrical resistance at high temperatures. Alumina is also a material stable at high temperatures and has a superior electrical insulation and higher hardness compared to that of aluminum nitride.

However, these recent ceramic susceptors fail to meet the ceramic properties, such as volume resistivity and thermal conductivity, required to withstand a harsher high-temperature processing environment. Aluminum nitride exhibits a rapid decrease in volume resistivity at 500°C, leading to leakage current. Moreover, alumina has a very low thermal conductivity of 20 to 30 W/m·K at room temperature. The thermal conductivity of only 20 to 30 W/m·K at room temperature may lead to problems such as increased temperature uniformity deviation and reduced yield. Furthermore, when the temperature uniformity deviation of the thermal conductivity is large, thermal stress and thermal shock may shorten the product's lifespan.

Furthermore, even when using ceramic members such as sintered aluminum nitride or sintered alumina, there is still the problem of corrosion resistance being reduced by plasma, and contaminant particles being generated from the surface of the component by halogen gases (F, Cl, Br, I, or the like). Therefore, the industry has attempted to improve plasma corrosion resistance by coating the surface of the ceramic member with plasma-resistant fluorine-based materials such as YOF, AlF, LaF, and YF₃, or yttrium oxide (Y₂O₃) through the methods such as plasma spray coating, aerosol deposition, PVD, or CVD. However, in this case, the relative density is low, so the coating layer peels off from the base material or pores are formed in the coating layer, which not only reduces plasma corrosion resistance but also causes the powder constituting the coating layer to be lost, generating fine particles and increasing the process cost.

To solve these problems, various attempts are being made to use Yttrium Aluminum Garnet (YAG, Y₃Al₅O₁₂), which is a ceramic material with high thermal stability, creep resistance, optical properties, and plasma resistance as a compound of yttria and alumina, as the coating material. However, the development of these coating materials alone has problems such as the formation of pores or cracks at the bonding interface between the base material and the coating layer, which causes the coating layer to peel off or be damaged, due to the difficulty in forming a dense bond due to the difference in physical properties and thermal characteristics between the base material and the coating material.

Therefore, there is a need to develop a novel ceramic member that has excellent volume resistivity and thermal conductivity in recent semiconductor processes using high-temperature environments and high-power plasmas, may be coated in a method of coating a component having plasma corrosion resistance on the surface of the ceramic member so that the coating layer does not peel off from the base material and fine particles are not generated, and densely bonding the base material and the coating layer, and thus, has excellent plasma resistance and durability.

### [Disclosure]

### [Technical Problem]

Therefore, an object of the present invention is to provide a ceramic susceptor, which has improved volume resistivity and thermal conductivity as well as plasma resistance, durability, and particle resistance by coating a ceramic sintered body base material having excellent volume resistivity at high temperature and thermal conductivity at room temperature with a core/shell structure material including a material, which has various physical property advantages such as plasma resistance and durability and is similar or identical to the base material.

### [Technical Solution]

In order to achieve the above-described object, the present invention provides a ceramic susceptor including: a ceramic plate layer; and a coating layer positioned on the ceramic plate layer and formed by sintering a core/shell structure material, wherein the ceramic plate layer includes alumina (Al₂O₃) and aluminum nitride (AlN) and does not include a secondary phase of an aluminum oxynitride (AlON) phase, and the coating layer has a structure in which particle phases constituting a shell form a continuous phase along the grain boundary of core particle phases.

### [Advantageous Effects]

According to the ceramic susceptor including the core/shell structure material as the coating layer of the present invention, it is possible to improve volume resistivity and thermal conductivity as well as plasma resistance, durability, and particle resistance by coating a ceramic sintered body base material having excellent volume resistivity at high temperature and thermal conductivity at room temperature with a core/shell structure material including a material, which has various physical property advantages such as plasma resistance and durability and is similar or identical to the base material.

### [Brief Description of Drawings]

FIG. 1 is a cross-sectional view of core/shell structure material particles included in a ceramic susceptor of the present invention.
FIG. 2 is a cross-sectional view schematically illustrating the internal structure of a coating layer formed by sintering the core/shell structure material included in the ceramic susceptor of the present invention.
FIG. 3 is an XRD graph illustrating physical properties of the ceramic susceptor according to sintering temperature.
FIG. 4 is a graph illustrating the correlation between a content of alumina and the sintering temperature.
FIG. 5 is an XRD graph of the coating layer of the ceramic susceptor according to one embodiment of the present invention.
FIG. 6 is an XRD graph of a conventional ceramic susceptor.
FIG. 7 is an image of the coating layer of the ceramic susceptor according to one embodiment of the present invention, observed using a transmission electron microscope (TEM).
FIG. 8 is an image of the cross-section of the ceramic susceptor according to one embodiment of the present invention, observed using a scanning electron microscope (SEM).
FIG. 9 is an image of a cross-section of the coating layer of the ceramic susceptor according to one embodiment of the present invention, observed using a scanning electron microscope (SEM).
FIG. 10 is an image of a cross-section of a conventional ceramic susceptor, observed using a scanning electron microscope (SEM).
FIG. 11 is an image of a cross-section of a surface of the ceramic susceptor according to one embodiment of the present invention where a ceramic plate layer and a core/shell coating layer are bonded, observed using a scanning electron microscope (SEM, 800x magnification).
FIG. 12 is an image of a cross-section of the surface of the ceramic susceptor according to one embodiment of the present invention where the ceramic plate layer and the core/shell coating layer are bonded, observed using a scanning electron microscope (SEM, 2,000x magnification).

### [Best Mode]

Hereinafter, the present invention will be described in detail.

A ceramic susceptor according to the present invention includes a ceramic plate layer and a coating layer positioned on the ceramic plate layer and formed by sintering a core/shell structure material, wherein the ceramic plate layer includes alumina (Al₂O₃) and aluminum nitride (AlN) and does not include a secondary phase of an aluminum oxynitride phase (AlON phase), and the coating layer has a structure in which particle phases constituting a shell form a continuous phase along the grain boundary of core particle phases.

In addition, a separate coating layer containing components same as or different from the coating layer may be additionally positioned on the coating layer.

As semiconductor processes become increasingly miniaturized and highly integrated, the use of high-power plasma is inevitable. Accordingly, vacuum plasma equipment that utilizes high-temperature plasma is widely used for etching semiconductor devices or implementing other ultra-fine shapes. Therefore, the industry is using ceramic susceptors made of sintered aluminum nitride (AlN) or sintered alumina (Al₂O₃), which has superior plasma corrosion resistance, instead of existing metal susceptors. In particular, recently, semiconductor manufacturing processes are being performed in harsher environments, such as 600 to 700°C, to realize process miniaturization and increase the diameter of equipment for improving yield in the semiconductor processes. Moreover, in order to withstand this environment, the ceramic susceptor should satisfy ceramic characteristics such as a volume resistivity of 1.0E+10 to 1.0E+13 Ω·cm at 500°C and a thermal conductivity of 30 to 60 W/m·K or more at room temperature.

However, in the case of aluminum nitride, the volume resistivity decreases rapidly at 500°C, which tends to generate leakage current, and in the case of alumina, there is a problem that the thermal conductivity at room temperature is very low at the level of 20 to 30 W/m·K. The thermal conductivity of only 20 to 30 W/m·K at room temperature may lead to problems such as increased temperature uniformity deviation and reduced yield. Furthermore, when the temperature uniformity deviation of the thermal conductivity is large, thermal stress and thermal shock may shorten the product's lifespan. Therefore, as the base material that may be used at high temperatures of 500°C or more, the present applicant basically provides a ceramic plate that may prevent leakage current by having high volume resistivity even at temperatures of 500°C or more, and also has higher thermal conductivity at room temperature than usual, which may solve the above problems.

The ceramic plate layer included in the ceramic susceptor according to the present invention serves as the base material of the ceramic susceptor. The ceramic plate is a sintered body including alumina (Al₂O₃), which not only possesses excellent electrical insulation and high hardness but also is stable at high temperatures, and aluminum nitride (AlN), which is stable at high temperatures and possesses physical properties having excellent electrical insulation and thermal conductivity, as the main phases.

In particular, the present invention is characterized by solving both the problems that arise when alumina and aluminum nitride are used individually and the problems that arise when alumina and aluminum nitride are not mixed in an optimal ratio, by mixing the alumina and aluminum nitride in an optimal ratio. Specifically, by mixing alumina and aluminum nitride in an optimal ratio as in the present invention, the physical properties of the ceramic susceptor may be maximized by having a state in which the alumina phase and the aluminum nitride phase are evenly mixed and distributed without any change in the crystal phase, such as the secondary phase of the AlON phase not being generated. In addition, by performing the sintering process at an optimal temperature (less than 1,650°C, preferably 1,300°C or more and less than 1,650°C) in the process of preparing the ceramic plate layer, the formation of the secondary phase may be more thoroughly prevented. Accordingly, the ceramic plate layer satisfies the ceramic characteristics of having a volume resistivity of 1.0E+10 to 1.0E+13 Ω·cm at 500°C and a thermal conductivity of 30 to 60 W/m·K at room temperature.

The ceramic plate layer includes alumina in an amount exceeding 68 wt% and less than 99.8 wt%, preferably 70 to 95 wt%, more preferably 70 to 80 wt%, and most preferably 73 to 77 wt%. In addition, the ceramic plate layer includes aluminum nitride in an amount exceeding 0.2 wt% and less than 32 wt%, preferably 5 to 30 wt%, more preferably 20 to 30 wt%, and most preferably 23 to 27 wt%. When each of the alumina and the aluminum nitride does not satisfy the above content range, the volume resistivity at 500°C or the thermal conductivity at room temperature will not meet the requirements, and thus the ceramic properties that the volume resistivity of the ceramic plate layer at 500°C should be 1.0E+10 to 1.0E+13 Ω·cm and the thermal conductivity at room temperature should be 30 to 60 W/m·K will not be satisfied.

It is preferable that the purity of the alumina and aluminum nitride is 99% or more, and that their particles have a nano size, and it is preferable that both of them are used in the form of powder.

More specifically, the alumina particles may have a size ranging from nanometers to micrometers. For example, the alumina particles may be particles obtained by mixing alumina particles having a size of 3 to 5 µm and alumina particles having a size of about 50 nm in a weight ratio of about 7:3 and then pulverizing the mixture through a ball mill process. However, the particle size and mixing ratio may vary widely, and the ball mill process may be excluded, and thus the present invention is not limited to the above examples.

In addition, the average particle size (D50) of the aluminum nitride particles may be 0.5 to 1.5 µm, preferably 0.8 to 1.3 µm, and more preferably 0.9 to 1.2 µm. When the average particle size (D50) of the aluminum nitride particles is less than 0.5 µm, the reaction temperature may be lowered, which may cause a problem in that a secondary phase is generated by reacting with alumina at a low temperature. In addition, when the average particle size (D50) of the aluminum nitride particles exceeds 1.5 µm, a dense/close-packed structure with alumina may not be formed, which may cause a problem in that the density is lowered during the final sintering. In addition, in the present invention, it is preferable to exclude aluminum nitride particles having a nanometer size as much as possible.

Meanwhile, the ceramic plate layer may further include a dopant as needed. The dopant may be used for the purpose of further improving the thermal conductivity of the ceramic plate layer.

For example, when a conventional sintered body is applied to a substrate and a semiconductor ceramic heater or electrostatic chuck is used at a high temperature of 500°C or more, the substrate may be broken by thermal shock due to the rapid temperature change of the heating element. However, in order to improve the thermal shock resistance of the substrate, a dopant is mixed in and applied to the heater or electrostatic chuck, thereby efficiently transferring the heat of the heating element and preventing the substrate from being broken by thermal shock. Examples of such dopants include one or more of magnesium oxide (MgO), yttria (Y₂O₃), graphene, and rare earth composite oxides.

When the ceramic plate layer includes a dopant, the dopant may be included in an amount of 0.05 to 2 parts by weight, preferably 0.1 to 1 part by weight, and more preferably 0.2 to 0.8 parts by weight, based on 100 parts by weight of the total weight of the alumina and aluminum nitride. When the dopant is included in an amount of less than 0.05 parts by weight or not included at all based on 100 parts by weight of the total weight of the alumina and aluminum nitride, the problems that previously appeared may remain the same, or the effect that may be obtained by using the dopant may be significantly reduced, so that the degree of improvement in thermal conductivity may be minimal, and an unsintering problem may also occur. In addition, when the content of the dopant exceeds 2 parts by weight based on 100 parts by weight of the total weight of the alumina and aluminum nitride, the dispersion effect may decrease, the thermal conductivity may decrease, and the sintering density may tend to decrease. In addition, the color of the product may darken due to the influence of the dopant, or the color of the dopant may be expressed as it is. In addition, it is preferable that all dopants used in the present invention have a purity of 99% or more. In addition, it is preferable that each dopant is included in an amount of 0.05 to 0.5 wt%.

Magnesium oxide, which is one of the dopants, may be included to improve the thermal conductivity and volume resistivity of the ceramic plate layer. The magnesium oxide can induce the formation of a MgAl₂O₄ phase or a MgAlON phase through sintering with the alumina and/or aluminum nitride. However, when the MgAl₂O₄ phase or the MgAlON phase is formed in excessive amounts, the density may decrease, which may actually lower the thermal conductivity. Therefore, even when the same components are used, it is necessary to control the contents of the components. For example, in the present invention, at least one of the MgAl₂O₄ phase and the MgAlON phase included in the final ceramic susceptor may be present in an amount of less than 1 wt%, preferably less than 0.8 wt%, and more preferably 0.6 wt% or less, based on the total weight of the ceramic susceptor. In addition, there is no particular limitation on the particle size of the magnesium oxide, but it is preferable to exclude nanometer-sized particles that may exhibit a relatively weak effect.

The yttria (Y₂O₃) may be included to improve the thermal conductivity of the ceramic plate layer. The purity of the yttria is preferably 99% or more and in terms of improving physical properties through densification, the yttria particles preferably have a nano-size, and this yttria is preferably used in the form of a powder. More specifically, the average particle size (D50) of the yttria particles may be 50 to 150 nm, preferably 70 to 120 nm, and more preferably 90 to 100 nm. When the average particle size (D50) of the yttria particles is less than 50 nm, even if included in a trace amount, there is a concern that a problem may occur, such as the sintered body having the color (yellow, or the like) of the yttria particles due to the characteristics of the nano-level yttria powder. In addition, when the average particle size (D50) of the yttria particles exceeds 150 nm, an incomplete sintered body may be formed during sintering, which may cause a decrease in thermal conductivity due to a decrease in density. In particular, when the average particle size (D50) of the yttria particles is on the micrometer level, this problem may be more prominent.

The graphene may also be included to improve the thermal conductivity of the ceramic susceptor. The purity of the graphene is preferably 99% or more, the graphene particles have a nano-size, and such graphene is preferably used in the form of powder (graphene nanopowder, GNP). More specifically, the average particle size (D50) of the graphene particles may be 0.1 to 1.5 nm, preferably 0.3 to 1 nm, and more preferably 0.5 to 0.8 nm. When the average particle size (D50) of the graphene particles is less than 0.1 nm, the graphene particles may not be large enough to act as bridges between the graphene particles, and thus the effect of improving thermal conductivity may be minimal or non-existent. In addition, when the average particle size (D50) of the graphene particles exceeds 1.5 nm, the graphene particles may become entangled with each other and may not be well dispersed, which may cause a problem of reduced thermal conductivity due to a decrease in density.

Finally, the rare-earth composite oxide includes two or more rare-earth metals selected from the group consisting of scandium (Sc), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), and lutetium (Lu). The purity of the rare-earth composite oxide including such rare-earth metals is preferably 99% or more. The form of the rare-earth composite oxide is preferably a powder, and there is no particular limitation on the size of the powder particles.

The rare earth composite oxide can further improve the thermal conductivity of the ceramic susceptor, and furthermore, by using the rare earth composite oxide, the time required for dechucking may be reduced. The rare earth composite oxide may include two or more types of rare earth metals as described above, and preferably include two to five different rare earth metals.

Examples of the rare earth composite oxides including the two to five different rare earth metals include composite oxides including two different rare earth metals, such as europium-gadolinium composite oxide (EuGdO_{X}), samarium-gadolinium composite oxide (SmGdO_{X}), cerium-europium composite oxide (CeEuO_{X}), samarium-cerium composite oxide (SmCeO_{X}), gadolinium-samarium composite oxide (GdSmO_{X}), and lanthanum-cerium composite oxide (LaCeO_{X}); composite oxides including three different rare earth metals, such as samarium-cerium-europium composite oxide (SmCeEuO_{X}), gadolinium-cerium-lanthanum composite oxide (GdCeLaO_{X}), and europium-gadolinium-samarium composite oxide (EuGdSmO_{X}); composite oxides including four different rare earth metals, such as samarium-cerium-gadolinium-europium composite oxide (SmCeGdEuO_{X}) and gadolinium-samarium-europium-lanthanum composite oxide (GdSmEuLaOX); and composite oxides including five different rare earth metals, such as samarium-cerium-europium-gadolinium-lanthanum composite oxide (SmCeEuGdLaO_{X}); and in addition, any other oxide including two to five different rare earth metals (oxides) may be used without special limitation.

The rare earth composite oxide including the 2 to 5 different rare earth metals may include different types of rare earth metals in various mixing ratios. For example, the rare earth composite oxide including the 2 to 5 different rare earth metals may include two kinds of rare earth metals (oxides) in a weight ratio of 2.5 to 3.5:1, three kinds of rare earth metals (oxides) in a weight ratio of 1 to 3.5:0.5 to 2.5:1, four kinds of rare earth metals (oxides) in a weight ratio of 1.5 to 3.5:0.5 to 2.5:1, or five kinds of rare earth metals (oxides) in a weight ratio of 1 to 3:0.5 to 1.5:0.5 to 1.5:1 to 2:1, or the like, so that the effect of the target rare earth composite oxide may be maximized, and the rare earth metals (oxides) may be appropriately combined. For example, SmCeEuO_{X} may have a weight ratio of each rare earth metal (oxide) of 2:1:1, GdCeLaO_{X} may have a weight ratio of 3:2:1, EuGdSmO_{X} may have a weight ratio of 1.5:1.5:1, SmCeGdEuO_{X} may have a weight ratio of 2:1:1.5:1, GdSmEuLaO_{X} may have a weight ratio of 3:2:2:1, and SmCeEuGdLaO_{X} may have a weight ratio of 2:1:1:1.5:1.

In the rare earth composite oxide, one rare earth metal may be dissolved in the other (or any) rare earth metal oxide. Through this, the crystal structure of the rare earth metal oxide changes, and thus, the rare earth composite oxide may have an increased oxygen lattice defect compared to a single rare earth metal oxide. In this way, the rare earth composite oxide with an increased oxygen lattice defect has improved interfacial reactivity, and thus can effectively react with the interface or lattice oxygen of the components within the ceramic susceptor.

In addition, examples of rare earth metal oxides containing one rare earth metal include scandium oxide (Sc₂O₃), lanthanum oxide (La₂O₃), cerium oxide (CeO₂), praseodymium oxide (Pr₆O₁₁), neodymium oxide (Nd₂O₃), promethium oxide (Pm₂O₃), samarium oxide (Sm₂O₃), europium oxide (Eu₂O₃), gadolinium oxide (Gd₂O₃), terbium oxide (Tb₄O₇), dysprosium oxide (Dy₂O₃), holmium oxide (Ho₂O₃), erbium oxide (Er₂O₃), thulium oxide (Tm₂O₃), ytterbium oxide (Yb₂O₃), and lutetium oxide (Lu₂O₃), but the present invention does not include rare earth metal oxides containing only one rare earth metal as a dopant.

Meanwhile, although the dopant was described above as including at least one of magnesium oxide, yttria, graphene, and the other rare earth metal oxides other than yttria, it is preferable that the present invention basically includes magnesium oxide as the dopant. In addition, it is preferable to use magnesium oxide and graphene together as the dopant. In addition, it is more preferable to use magnesium oxide, graphene, and yttria together as the dopant. In addition, it is most preferable to use magnesium oxide, graphene, yttria, and a rare earth composite oxide together as the dopant.

When magnesium oxide and graphene are used together as dopants, the magnesium oxide may be included in an amount of 0.05 to 0.5 parts by weight, and the graphene may be included in an amount of 0.05 to 0.5 parts by weight, based on 100 parts by weight of the total weight of the alumina and aluminum nitride.

In addition, when magnesium oxide, graphene, and yttria are used together as dopants, the magnesium oxide may be included in an amount of 0.05 to 0.5 parts by weight, the graphene may be included in an amount of 0.05 to 0.5 parts by weight, and the yttria may be included in an amount of 0.05 to 0.5 parts by weight, based on 100 parts by weight of the total weight of the alumina and aluminum nitride.

In addition, when magnesium oxide, graphene, yttria, and rare earth composite oxides are used together as dopants, the magnesium oxide may be included in an amount of 0.05 to 0.5 parts by weight, the graphene may be included in an amount of 0.05 to 0.5 parts by weight, the yttria may be included in an amount of 0.05 to 0.5 parts by weight, and the rare earth composite oxide may be included in an amount of 0.05 to 0.5 parts by weight, based on 100 parts by weight of the total weight of the alumina and aluminum nitride.

Hereinafter, a coating layer formed on a ceramic plate layer of a ceramic susceptor according to the present invention will be described in detail.

Hereinafter, the term "yttrium-aluminum oxide" should be understood to mean at least one of the crystalline phase forms of yttrium-aluminum oxide, including Y₃Al₅O₁₂ (yttrium-aluminum garnet, hereinafter abbreviated as YAG), YAlO₃ (yttrium-aluminum perovskite, hereinafter abbreviated as YAP), Y₄Al₂O₉ (yttrium-aluminum monoclinic, hereinafter abbreviated as YAM), and combinations thereof. The terms "YAG" and "YAG phase" are used interchangeably in the present invention.

As used herein, the term "alumina" should be understood to be aluminum oxide including Al₂O₃, the term "yttria" should be understood to be yttrium oxide including Y₂O₃, and the term "spinel" should be understood to be magnesium aluminate spinel including MgAl₂O₄.

It should also be noted that the terms "Core" and "Core particle" are used interchangeably in the present invention, and the terms "Shell" and "Shell particle" are also used interchangeably in the present invention.

The coating layer formed on the ceramic plate layer is positioned on the ceramic plate layer and is formed by sintering a core/shell structure material.

In addition, the coating layer formed by sintering the core/shell structure material satisfies the high volume resistance and thermal conductivity required for electrostatic chucks or ceramic heaters, and has high strength/hardness and density and excellent plasma resistance properties.

A ceramic susceptor formed with such a coating layer on a ceramic plate layer has a low level of contamination with metals and particles, minimizing particle generation even when exposed to extreme conditions such as high temperatures and high-energy plasma during a semiconductor manufacturing process.

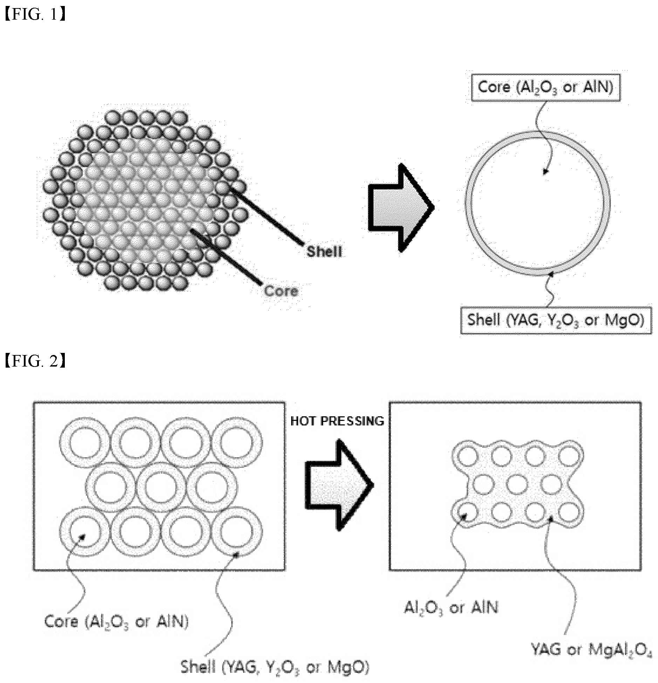

FIG. 1 is a cross-sectional view of a core/shell structure material particle included in a ceramic susceptor of the present invention. More specifically, as illustrated in FIG. 1, the core/shell structure material includes a core including an aluminum compound and a shell surrounding the core and coated on the surface of the core.

The core includes a ceramic material having high volume resistivity and thermal conductivity, and preferably includes at least one of aluminum oxide and aluminum nitride (AlN) among aluminum compounds, and the aluminum oxide is preferably alumina (Al₂O₃). In addition, the core may further include various ceramic materials having high volume resistivity and thermal conductivity and used in conventional electrostatic chucks and ceramic heaters. However, it may be more preferable that the core includes only an aluminum compound. In addition, the aluminum compound is preferably included in the core in the form of a powder, and therefore, the core may have a form composed of particles.

The shell coated on the surface of the core includes a metal or ceramic mixture material having excellent plasma resistance.

The plasma-resistant metal or ceramic compound may be exemplified by one selected from the group consisting of yttrium-aluminum oxide selected from the group consisting of yttrium-aluminum garnet (Y₃Al₅O₁₂, YAG), yttrium-aluminum perovskite (YAlO₃, YAP) and yttrium-aluminum monoclinic (Y₄Al₂O₉, YAM), yttrium oxide, magnesium oxide, yttria-alumina-silica (or yttrium aluminosilicate, Y₂O₃-Al₂O₃-SiO₂, YAS), magnesium silicate (Mg₂SiO₄) and mullite (3Al₂O₃·2SiO_{2,} and among these, yttrium-aluminum garnet (YAG, Y₃Al₅O₁₂), yttria (Y₂O₃) or magnesium oxide may be preferred as the plasma-resistant metal or ceramic compound.

In addition, it is preferable that the plasma-resistant metal or ceramic compound is included in the shell in the form of a powder, and therefore, the shell may have a form composed of particles.

Accordingly, the core/shell structure material may be, for example, in the form of yttrium-aluminum oxide shell particles, yttria shell particles, or magnesium oxide shell particles coated on the surface of alumina core particles or aluminum nitride core particles.

Meanwhile, the YAG shell particles may be formed by directly coating commercially available YAG powder on the surface of the core particle, or by coating YAG powder prepared by reaction sintering a powder mixture of yttrium oxide (e.g., Y₂O₃) and aluminum oxide (e.g., Al₂O₃) on the surface of the core particle.

However, it is preferable that by subjecting the powder coated with yttria on the surface of the alumina core particle or the surface of the aluminum nitride core particle to heat treatment and ball milling, all or at least a portion of the yttria is converted into a YAG phase by a reaction between the alumina or aluminum nitride and the yttria, so that the converted YAG phase surrounds the surface of the alumina core particle or the surface of the aluminum nitride core particle.

In other words, it is preferable to form the aluminum nitride-YAG core/shell structure material or the alumina-YAG core/shell structure material by forming an yttria coating layer on the surface of the aluminum nitride core particle or the surface of the alumina core particle, and performing heat treatment and ball milling treatment so that the yttria coated on the surface of the core particle can react with the aluminum nitride or alumina within the coating layer and be converted into a YAG phase, thereby forming the aluminum nitride-YAG core/shell structure material or the alumina-YAG core/shell structure material.

In this case, it is preferable to appropriately adjust the content ratio of the alumina and yttria or the content ratio of the aluminum nitride and yttria so that the yttria coated on the surface of the alumina core particle or the aluminum nitride core particle for forming the YAG shell is completely converted into a YAG phase by reacting with the alumina or aluminum nitride, and at the same time, the remaining amount of alumina or aluminum nitride inside the shell converted into the YAG phase can form a core.

It is preferable that the content ratio of the alumina and yttria or the content ratio of the aluminum nitride and yttria in the core/shell structure material be adjusted according to the content of the YAG shell so that the YAG shell may be formed by converting all of the yttria into a YAG phase through the reaction of the alumina or aluminum nitride with yttria. In this case, the content of the alumina core particles or aluminum nitride core particles relative to the total weight of the core/shell structure material is preferably 50 to 85 wt%, and the content of the YAG shell particles is preferably 15 to 50 wt%.

When the content of the YAG shell particles is less than 15 wt%, the hardness and density of the coating layer prepared through sintering of the core/shell structure material are reduced, making it difficult to secure sufficient plasma resistance. Furthermore, when the content of the YAG shell particles exceeds 50 wt%, the volume resistivity and thermal conductivity of the ceramic susceptor due to the coating layer are reduced, making it difficult to apply the material to an electrostatic chuck or ceramic heater.

Meanwhile, when the core/shell structure material is alumina core particles or aluminum nitride core particles coated with yttria shell particles, the content of the alumina core particles or aluminum nitride core particles is preferably 70 wt% to 90 wt%, and the content of the yttria shell particles is preferably 10 wt% to 30 wt%.

Even in this case, the yttria shell particles are converted into a YAG phase through reaction sintering of the alumina core particles or aluminum nitride core particles with the yttria shell particles during the sintering process. In this case, the content of the alumina core particles or aluminum nitride core particles with respect to the total weight of the coating layer is preferably 50 wt% to 85 wt%, and the content of the YAG is preferably 15 wt% to 50 wt%.

Here, the thickness ratio of the core and shell may be appropriately adjusted to achieve a composition that satisfies the content ranges of alumina or aluminum nitride, which is the core component, and YAG or yttria, which is the shell component, of the core/shell structure material.

More specifically, when the particle radius of the core is R₁ and the thickness of the shell (i.e., the distance from the outermost surface of the core to the outermost surface of the shell) is R₂, if the core/shell structure material is composed of an aluminum nitride-YAG or alumina-YAG structure, the R₁/R₂ value is preferably set to 4 to 25. Furthermore, when the core/shell structure material is composed of an aluminum nitride-yttria or alumina-yttria structure, the R₁/R₂ value is preferably set to 9 to 42.

In addition, when the core/shell structure material is alumina core particles or aluminum nitride core particles coated with magnesium oxide shell particles, the content of the alumina core particles or aluminum nitride core particles is preferably 97.2 wt% to 85 wt%, and the content of the magnesium oxide particles is preferably 2.8 wt% to 15 wt%.

In addition, during the sintering process, the magnesium oxide shell particles are converted into a magnesium aluminate spinel (MgAl₂O₄, hereinafter referred to as "spinel") phase through reaction sintering of the alumina core particles or aluminum nitride core particles with the magnesium oxide shell particles. In this case, the content of the alumina or aluminum nitride relative to the total weight of the coating layer is preferably 50 wt% to 90 wt%, and the content of the spinel is preferably 10 wt% to 50 wt%.

Here, the content of the alumina core particles or aluminum nitride core particles and the magnesium oxide shell particles may be controlled by adjusting the thickness ratio of the alumina core particles or aluminum nitride core particles and the magnesium oxide shell particles.

More specifically, when the particle radius of the core is R₁ and the thickness of the shell (i.e., the distance from the outermost surface of the core to the outermost surface of the shell) is R₂, if the core/shell structure material is composed of an aluminum nitride-magnesium oxide or alumina-magnesium oxide structure, the R₁/R₂ value is preferably 16 to 114.

Meanwhile, the shell may further include at least one selected from the group consisting of yttria-alumina-silica (Y₂O₃-Al₂O₃-SiO₂, YAS), carbon (C), boron nitride (BN), silicon carbide (SiC), scandium (Sc), and niobium (Nb).

Next, the coating layer formed by sintering the core/shell structure material and positioned on the ceramic plate layer will be described in more detail. FIG. 2 is a cross-sectional view schematically illustrating the internal structure of the coating layer formed by sintering the core/shell structure material included in the ceramic susceptor of the present invention.

The coating layer is formed by sintering the core/shell structure material described above, and has a structure in which the particle phases constituting the shell form a continuous phase along the grain boundary of the core particle phases. Here, the term "continuous phase" refers to an aggregation (combination) of individual shell particle phases surrounding multiple core particle phases. Therefore, the overall appearance of the coating layer has a form in which multiple core particle phases are partially positioned within the continuous phase composed of shells, as illustrated in FIG. 2.

The coating layer positioned on the ceramic plate layer is formed by mixing aluminum nitride or alumina material with high volume resistivity and thermal conductivity with YAG or spinel material with excellent plasma resistance, and is sintered using the core/shell structure material such that the aluminum nitride or alumina phase is surrounded by the YAG or spinel phase and is not exposed to plasma.

That is, the coating layer may be formed by sintering the above-described aluminum nitride-YAG core/shell structure material or the alumina-YAG core/shell structure material, or by sintering the above-described aluminum nitride-yttria core/shell structure material, the alumina-yttria core/shell structure material, the aluminum nitride-magnesium oxide core/shell structure material, or the alumina-magnesium oxide core/shell structure material.

When the aluminum nitride-YAG core/shell structure material or the alumina-YAG core/shell structure material is sintered, as illustrated in FIG. 2, the YAG phases constituting the shell form a continuous YAG phase along the grain boundary of the aluminum nitride or alumina phases constituting the core.

That is, the aluminum nitride or alumina particles are sintered while surrounded by the continuous YAG phases, preventing them from being exposed on the surface of the coating layer.

Therefore, due to the internal crystal structure described above, even when the coating layer is exposed to plasma, the exposure of the aluminum nitride or alumina particles to plasma is minimized, and only the YAG phase, which has relatively low chemical activity and excellent chemical erosion resistance, is exposed to plasma, thereby improving the plasma resistance of the coating layer to a level equivalent to or similar to that of a YAG bulk sintered body.

Furthermore, due to the aluminum nitride or alumina phases present within the coating layer, which are surrounded by the continuous YAG phases, the physical properties of the coating layer may be maintained at a level equivalent to or similar to that of conventional aluminum nitride or alumina bulk sintered bodies even in the volume resistivity and thermal conductivity.

Furthermore, as may be seen from the above description, since the coating layer possesses physical properties similar to the ceramic plate layer, high-strength bonding to the ceramic plate layer is possible, thereby significantly reducing coating layer delamination and particle generation compared to conventional materials.

Meanwhile, when the coating layer is formed by sintering the aluminum nitride-yttria core/shell structure material or the alumina-yttria core/shell structure material, during the sintering process, all or at least a portion of the yttria is converted into a YAG phase by reaction sintering of the yttria constituting the shell and the aluminum nitride or alumina constituting the core.

In this case, the YAG phase reacts with the yttria and forms a continuous YAG phase along the grain boundary of the remaining aluminum nitride or alumina phases, similar to the sintering of the above-described aluminum nitride-YAG core/shell structure material or alumina-YAG core/shell structure material.

Therefore, even in the case of the coating layer formed through sintering the aluminum nitride-yttria core/shell structure material or the alumina-yttria core/shell structure material, it has the same internal crystal structure as the coating layer formed through sintering the aluminum nitride-YAG core/shell structure material or the alumina-YAG core/shell structure material, thereby ensuring excellent plasma resistance properties, and even maintaining the high volume resistivity and thermal conductivity required by conventional electrostatic chucks or ceramic heaters.

In addition, when forming a coating layer through sintering of the aluminum nitride-magnesium oxide core/shell structure material or the alumina-magnesium oxide core/shell structure material, during the sintering process, all or at least a portion of the magnesium oxide is converted into a spinel phase by reaction sintering of the magnesium oxide constituting the shell and the aluminum nitride or alumina constituting the core, and at this time, the converted spinel phase reacts with the magnesium oxide to form a continuous spinel phase along the grain boundary of the remaining aluminum nitride or alumina phases.

Therefore, even in the case of a coating layer formed through sintering of the aluminum nitride-magnesium oxide core/shell structure material or the alumina-magnesium oxide core/shell structure material, the aluminum nitride particles or the alumina particles are surrounded by a spinel phase continuously formed along their grain boundaries, thereby minimizing exposure to plasma, and since only the spinel phase, which has relatively low chemical activity and excellent chemical erosion resistance, is exposed to plasma, not only can excellent plasma resistance properties be secured, but also the high volume resistivity and thermal conductivity required by a typical electrostatic chuck or ceramic heater may be maintained.

In the coating layer formed in this way, the content of alumina or aluminum nitride present within the alumina-YAG core/shell coating layer or the aluminum nitride-YAG core/shell coating layer is preferably 50 wt% to 85 wt%, and the content of the YAG is preferably 15 wt% to 50 wt%. Additionally, the content of alumina or aluminum nitride within the alumina-spinel core/shell coating layer or the aluminum nitride-spinel core/shell coating layer is preferably 50 wt% to 90 wt%, and the content of the spinel is preferably 10 wt% to 50 wt%.

When the content of the alumina or aluminum nitride deviates from the above content range and is in less than 50 wt%, the volume resistivity and thermal conductivity of the ceramic susceptor due to the coating layer will be reduced, hindering its application as an electrostatic chuck or ceramic heater. Furthermore, the bonding strength with the ceramic plate layer may also be weakened. In addition, when the alumina or aluminum nitride content exceeds the upper limit of the above range, the content of YAG or spinel phase within the coating layer will be low, resulting in deteriorated plasma resistance properties.

Furthermore, when the content of the YAG or spinel is less than the lower limit of the above range, it is difficult to expect plasma resistance properties equivalent to or similar to those of YAG or yttria bulk sintered bodies. In addition, when the content of the YAG or spinel exceeds 50 wt%, volume resistivity and thermal conductivity may decrease, making application to electrostatic chucks or ceramic heaters difficult. Furthermore, the bonding strength with the ceramic plate layer may also be weakened.

Here, the sintering performed when forming the coating layer is a method of forming bulk materials from powders using heat, pressure, and/or energy, which may be accomplished through various sintering methods commonly used to sinter ceramic materials, and preferably, may be accomplished by hot pressing.

In particular, when forming a coating layer using an aluminum nitride-yttria core/shell structure material or an alumina-yttria core/shell structure material, since there may be a problem in that the YAG phase is hardly formed due to the reaction sintering between aluminum nitride-yttria or alumina-yttria not proceeding smoothly in general pressureless sintering, it is preferable to prepare it using a hot-press sintering process.

In one embodiment described above, a coating layer having excellent plasma resistance, and high volume resistivity and thermal conductivity was described by forming a continuous YAG or spinel phase along the grain boundary of the aluminum nitride or alumina phases constituting the core through sintering the core/shell structure material.

However, the present invention is not limited thereto, and in addition to YAG or spinel, at the grain boundary of the aluminum nitride or alumina phases, at least one selected from the group consisting of Yttria-Alumina-Silica (YAS or Yttrium aluminosilicate, Y₂O₃-Al₂O₃-SiO₂), carbon (C), boron nitride (BN), silicon carbide (SiC), scandium (Sc), and niobium (Nb) may be further positioned.

These additional components, together with the YAG or spinel phase, are evenly dispersed along the grain boundary of the aluminum nitride or alumina phases and distributed within the coating layer, thereby further enhancing the thermal conductivity, mechanical strength, hardness, and density of the coating layer. Consequently, the overall physical properties of a ceramic susceptor prepared using the coating layer are further enhanced.

Additionally, the additional components may be included in the process of forming the shell of the core/shell structure material, or may be added to the coating layer by being mixed and sintered together with the core/shell structure material in the process of preparing the coating layer through sintering of the core/shell structure material.

Therefore, the additional components, together with the shell component, are evenly dispersed while forming a continuous phase along the grain boundary of the aluminum nitride and alumina phases constituting the core, thereby enhancing the overall physical properties of the coating layer, such as thermal conductivity, mechanical strength and hardness, and density.

As described above, the present invention provides a coating layer in which a continuous YAG or spinel phase is formed along the grain boundary of the alumina or aluminum nitride phases using the core/shell structure material, thereby exhibiting excellent plasma resistance and durability.

Furthermore, the core/shell structure material and the coating layer using it possess high strength/hardness and density, which may minimize corrosion and erosion characteristics and particle and/or metal contamination in the extreme environments of semiconductor processing.

In particular, the coating layer possesses the excellent plasma resistance and durability described above, while possessing the high volume resistivity and thermal conductivity required for the preparation of electrostatic chucks or ceramic heaters, and also possesses physical properties similar to the ceramic plate layer, thereby preparing a ceramic susceptor with excellent performance that can reduce coating layer delamination and particle generation by ensuring excellent bonding strength when formed on the ceramic plate layer.

Furthermore, the coating layer utilizes a core/shell structured ceramic material, thereby reducing the content of expensive yttria, and thus offering the advantage of lowering manufacturing costs compared to conventional methods.

Here, a method for preparing a coating layer using the core/shell structure material will be described.

First, the method for preparing the core/shell structure material includes the steps of: mixing and reacting an aluminum compound; and a plasma-resistant metal or ceramic compound, and may further include performing ultrasonic treatment during the mixing and reaction.

The ultrasonic treatment is intended to improve the dispersibility of the mixture, reactant, or reaction product, thereby promoting uniform particle distribution, which has no specific restrictions on the timing or frequency of the ultrasonic treatment performance, such as after all raw materials have been added, or after only one raw material has been added.

A linker, such as urea (CO(NH₂)₂), may be separately added before, after, or during the addition of raw materials. Stirring may also occur simultaneously with the addition of raw materials. Furthermore, the reaction between the raw materials may be performed in the presence of Di water (3-distilled water).

For example, an aluminum compound may be supplied to a reactor at about 90°C in the presence of Di water (3-distilled water), stirred, and then performed ultrasonic treatment at about 60°C for about 15 minutes. In this case, an additional stirring process may be performed for about 15 minutes to raise the temperature to about 90°C again. Next, after adding the linker to the reactor, ultrasonic treatment is performed at about 60°C for about 15 minutes after about 2 minutes, and a stirring process may be performed for about 15 minutes to raise the temperature to about 90°C again. Furthermore, one or more of the above processes may be repeated 2 to 6 times, preferably 3 to 5 times. Subsequently, another raw material, a plasma-resistant metal or ceramic compound, is additionally added to the reactor, and then ultrasonic treatment is performed at about 60°C for about 15 minutes after about 2 minutes, and a stirring process is performed for about 15 minutes to raise the temperature to about 90°C again. Finally, a core/shell structure material may be synthesized by additionally performing the stirring process for several minutes to several hours.

Meanwhile, a washing process using Di water (3-distilled water) and alcohol may be also performed to remove unreacted residual linker and other impurities, and this washing process may be repeated multiple times.

Furthermore, by drying the synthesized core/shell structure material at a temperature of about 70 to 90°C for 1 to 48 hours, preferably 12 to 36 hours, it is possible to obtain a core/shell structure material with higher purity.

Finally, the core/shell structure material prepared as described above may be crushed using a ball mill equipment or sintered through hot pressing to prepare a coating layer with a structure in which the shell particle phases form a continuous phase along the grain boundaries of the core particle phases.

Here, the conventional preparing methods for yttrium-aluminum garnet (Y₃Al₅O₁₂, YAG), which may be included in the "shell" will be briefly described. Conventional YAG preparing methods include sol-gel combustion, hydrothermal synthesis, co-precipitation, etc.

First, the sol-gel combustion is a method capable of preparing "high-purity powders with a uniform composition and fine particles", and since most of the prepared nanoparticles have an amorphous phase, a heat treatment process is required for crystallization. Typically, temperatures of 800°C or higher require a certain amount of time to form a crystal phase, which increases particle size and increases manufacturing costs.

The hydrothermal synthesis may prepare "crystalline powders and powders with spherical and small particle sizes" at relatively low temperature (200°C, 168 h). However, the synthesis process includes interactions between the powder and water, making it difficult to synthesize a composite oxide with a uniform composition. Furthermore, the process requires a significant amount of time.

The co-precipitation is a method of simultaneously precipitating various different ions from aqueous or non-aqueous solutions, and during the YAG preparing process, the powder-based raw materials exist in their individual ion forms, allowing for uniform dispersion. However, the precipitation process may be incomplete due to the co-precipitation of impurities or insufficient dispersion.

Therefore, to synthesize YAG core/shell structure, high-purity particles should be prepared, which requires a highly uniform composition.

Accordingly, the applicant has applied a method based on co-precipitation, but with the addition of ultrasonic treatment, to improve the dispersibility of mixtures, reactants, or reaction products, thereby inducing a uniform particle distribution.

Meanwhile, by forming a reaction layer through reaction sintering at the interface between the ceramic plate layer and the coating layer, the stress caused by differences in physical properties, such as microstructure and coefficient of thermal expansion, between the ceramic plate layer and the coating layer is reduced, thereby further stabilizing the coating interface.

Conventionally, yttria or Y-based compounds were coated on AlN or Al₂O₃ ceramic plates, but after coating, stress caused by differences in physical properties, such as microstructure and coefficient of thermal expansion, at the interface resulted in a delamination phenomenon. This delamination phenomenon was particularly more prominent in high-temperature environments of 500°C or higher.

However, the applicant has formed a coating layer on a ceramic plate containing AlN and Al₂O₃ using a hot-press sintering process (formed by sintering a core/shell structure material). In particular, by making the core component within the coating layer and the component constituting the ceramic plate layer similar or identical, differences in physical properties, such as thermal expansion coefficient, are minimized, enabling dense bonding. Consequently, the degree of coating layer delamination and particle generation is significantly reduced compared to conventional methods, resulting in improved densification, hardness, and density.

Furthermore, as described above, the coating layer has a structure in which the shell particle phases form a continuous phase along the grain boundary of the core particle phases, and in this case, a key feature of the present invention is that the material forming the continuous phase, such as yttrium-aluminum garnet (Y₃Al₅O₁₂, YAG), exhibits its own plasma resistance properties independently of the effects of the core component.

Furthermore, by forming the coating layer using the sintering method described above, a reaction layer may be generated at the interface between the ceramic plate layer and the coating layer through reaction sintering.

This reaction layer is generated by reaction sintering using high-temperature and highpressure energy, which stabilizes the microstructure of the interface between the ceramic plate layer and the coating layer, and relieves the stress caused by differences in physical properties, such as thermal expansion coefficient, between the different materials constituting the ceramic plate layer and the coating layer, thereby allowing the coating layer to remain stable without delamination even in a high-temperature environment of 500°C or higher.

For one example, when a 'coating layer whose continuous phase is yttrium-aluminum garnet (YAG, Y₃Al₅O₁₂) or yttria (Y₂O₃)' is formed on a ceramic plate, an yttrium-aluminum garnet (YAG, Y₃Al₅O₁₂) reaction layer may be further formed at the interface between the ceramic plate layer and the coating layer by reaction sintering of the yttrium component included in the coating layer and the aluminum or alumina component present in the ceramic plate layer.

As another example, when a 'coating layer having a continuous phase of magnesium oxide' is formed on a ceramic plate, a magnesium aluminate spinel (MgAl₂O₄) reaction layer may be further formed at the interface between the ceramic plate layer and the coating layer by reaction sintering of the magnesium component included in the coating layer and the aluminum or alumina component present in the ceramic plate layer.

Next, a method for preparing a ceramic susceptor according to the present invention will be described.

The method for preparing the ceramic susceptor includes the steps of: 1) preparing a ceramic plate layer; and 2) forming a coating layer on the ceramic plate layer.

In addition, the ceramic plate layer may be prepared through the steps of a) mixing alumina (Al₂O₃), aluminum nitride (AlN), an alcohol compound, and a binder, b) drying the mixture to prepare a powder from which the alcohol compound component has been removed, c) compressing and molding the dried powder to prepare a preform processed into a predetermined shape, d) degreasing the prepared preform to remove the binder component, and e) sintering and polishing the degreasing preform.

In addition, if necessary, a dopant may be added and mixed in the step a), and examples of such dopants may include at least one of magnesium oxide (MgO), yttria (Y₂O₃), graphene, and rare earth composite oxides.

The alcohol compound used in the step a) is used to appropriately mix the raw materials, and may include, for example, an alcohol compound having 1 to 5 carbon atoms, specifically, ethanol, methanol, and isopropyl alcohol. Similarly, the binder used in the step a) is intended to enhance the bonding strength of the raw materials, and examples thereof may include polyvinyl alcohol (PVA) and polyvinyl butyral (PVB).

The step b) is a step of drying the powder mixture mixed in the step a) to remove the alcohol component, and the drying may be performed using methods known in the art, such as spray drying or vacuum drying, and the drying time can vary depending on the physical properties of the intended ceramic susceptor.

The step c) includes compressing and molding the dried powder to prepare a preform processed into a predetermined shape. The compression molding is the first molding (i.e., the first molding) process for controlling the powder dried in the step b) to the desired size and shape, and examples thereof may include press molding. In this case, to prepare a product with a more precise specification, cold isostatic pressing (CIP) may be additionally performed, if necessary. The press molding is preferably performed at room temperature and in a normal atmosphere, but is not limited thereto. The molding atmosphere should be such that it does not affect the molding of the mixture. Furthermore, after the molding process in the step c), processing using a green processing method (also called "live processing" performed prior to sintering) may be performed to prepare a preform.

The step d) is a step for degreasing the prepared preform to remove the binder component. The degreasing process removes the binder and oily contaminants and may be performed at a temperature of 350 to 600°C for up to 60 hours.

The step e) is a step for sintering (second molding) and polishing the degreased preform to prepare a ceramic substrate. The sintering is a second molding (i.e., second molding) process to further improve the volume resistivity of the ceramic susceptor, and is preferably performed using a hot-press sintering process. Furthermore, when the degreased preform is sintered at a temperature of 1,650°C or higher, alumina and aluminum nitride react to form an AlON phase, which causes a problem of lowering thermal conductivity. Therefore, the sintering in the step e) should be performed at a temperature of less than 1,650°C, preferably at a temperature of 1,300°C or higher and less than 1,650°C.

Next, to form a coating layer on the prepared ceramic plate layer, the following steps need to be performed: a) mixing and reacting an aluminum compound and a plasma-resistant metal or ceramic compound to prepare a core/shell structure material; b) dispersing the prepared core/shell structure material in a solvent to prepare a coating solution; c) spraying the prepared coating solution onto the ceramic plate layer; and d) drying the sprayed coating solution and then performing hot pressing to form a coating layer.

The step a) may further include an ultrasonic treatment step during the mixing and reaction. Furthermore, the details of the raw materials in the step a) and the specific method for preparing the core/shell structure material are as described above.

The solvent in the step b) may be a typical organic solvent, such as an alcohol-based compound.

There are no special restrictions on the spraying in the step c), as any known spraying method for forming a coating layer, such as an air spray method, may be applied.

The drying in the step d) may be performed, for example, 10 minutes at room temperature, but is not limited thereto, and may vary depending on the coating amount or other circumstances.

The hot pressing in the step d) may be performed, for example, at a temperature of 1,300 to 1,650°C and at a pressure of 100 to 200 bar for 1 to 24 hours, but is not limited thereto, and may also be appropriately changed in consideration of circumstances, or the like.

Meanwhile, after preparing the core/shell structure material in the step a) and before performing the hot pressing in the step d), a process of crushing the core/shell structure material for 2 hours using a planetary ball mill may be added.

When a coating layer (formed by sintering a core/shell structure material) is provided onto a ceramic plate layer containing AlN and Al₂O₃ through the above process, the core and ceramic plate layer components are partially in direct contact, resulting in a sintered structure, thereby minimizing differences in physical properties, such as thermal expansion coefficient, and thus enabling dense bonding.

This significantly reduces the degree of coating layer delamination and particle generation compared to conventional coatings, resulting in improved densification, hardness, and density.

Furthermore, the shell, where particle phases form a continuous phase along the grain boundary of core particle phases, exhibits its own plasma resistance properties independently, separate from the effects exerted by the core component. This mechanism, where each component (core and shell) of the coating layer exerts its own individual effects, is a unique feature of the present invention that has not been previously observed.

The ceramic susceptor of the present invention, prepared using the above-described preparing method, may be applied to various devices or components used in semiconductor manufacturing processes, and among these, it is preferable to apply it as a material for heaters or electrostatic chucks used in semiconductor manufacturing processes. However, its application is not particularly limited, as it may also be used in fields that utilize ceramic materials under high-temperature plasma environments.

Hereinafter, the present invention will be described in more detail through specific examples. The following examples are intended to illustrate the present invention and are not intended to limit the present invention.

### [Preparation Examples 1-7] Preparation and physical properties evaluation of ceramic plates

To determine the optimal mixing ratio of alumina and aluminum nitride, the raw materials were mixed in the ratios illustrated in Table 1 below. Additionally, trace amounts of ethanol and polyvinyl butyral (binder) were mixed and dried. Next, the dried mixture was press-molded and processed to prepare a preform. Subsequently, the preform was degreased at a temperature of 500°C for 30 hours, and then the degreased preform was sintered in a high-temperature pressurized sintering furnace (250 bar pressure, 1,630°C temperature) and polished to prepare ceramic plates.

Then, the volume resistivity and thermal conductivity of each prepared ceramic plate were measured. Specifically, a voltage of 500 V/mm was applied to each prepared ceramic plate, and then the current was measured (measured under vacuum atmosphere and room temperature) after 1 minute to calculate the volume resistivity. Furthermore, specimens were prepared according to ASTM C0408-88R11 using a LFA 467 instrument from NETZSCH company, and then measured at room temperature to calculate the thermal conductivity. The results are illustrated in Table 2 below.

**[Table 1]**

| | Al₂O₃:AlN (Weight Ratio) |
|---|---|
| Preparation Example 1 | 100 : 0 |
| Preparation Example 2 | 99.8 : 0.2 |
| Preparation Example 3 | 95 : 5 |
| Preparation Example 4 | 85 : 15 |
| Preparation Example 5 | 75 : 25 |
| Preparation Example 6 | 68 : 32 |
| Preparation Example 7 | 60 : 40 |

**[Table 2]**

| | Volume resistivity (@ 500°C, Ω·cm) | Thermal conductivity (@ room temperature, W/m·K) | Density (g/cm³) | Hardness (Gpa) | XRD results (wt%) | |
|---|---|---|---|---|---|---|
| | | | | | Al₂O₃ | AlN |
| Preparation Example 1 | 1.6E+13 | 23.2 | 3.957 | 17.2 | 100 | 0 |
| Preparation Example 2 | 1.1E+13 | 28.4 | 3.959 | 17.1 | 99.5 | 0.5 |
| Preparation Example 3 | 3.3E+11 | 31.7 | 3.896 | 16.5 | 94.7 | 5.3 |
| Preparation Example 4 | 8.8E+10 | 33.2 | 3.801 | 15.1 | 83.8 | 16.2 |
| Preparation Example 5 | 3.0E+10 | 35.1 | 3.755 | 14.7 | 76.1 | 23.9 |
| Preparation Example 6 | 9.8E+09 | 36.3 | 3.696 | 14.2 | 67.1 | 32.9 |
| Preparation Example 7 | 5.3E+08 | 42.1 | 3.625 | 13.6 | 59.7 | 40.3 |

| | | | | | | |
|---|---|---|---|---|---|---|
| * Al₂O₃ and AlN units: wt% | | | | | | |

As illustrated in Tables 1 and 2 above, the proportion of aluminum nitride phase also varies depending on the aluminum nitride addition ratio, and accordingly, the volume resistivity at high temperatures and the thermal conductivity at room temperature are varied.

More specifically, changes in physical properties were confirmed depending on the aluminum nitride addition ratio, and XRD results illustrated that no AlON phase was generated in any of the final products of Preparation Examples 1 to 7. Preparation Examples 3 to 5 exhibited satisfactory volume resistivity and thermal conductivity, and Preparation Example 5, which mixed alumina and aluminum nitride in a weight ratio of 75:25, exhibited the best performance overall.

This demonstrates that when the aluminum nitride content is too low, the Al₂O₃ phase is formed as the primary phase, resulting in little improvement in thermal conductivity. However, when the aluminum nitride content is excessive, the proportion of the AlN phase increases, improving thermal conductivity but decreasing volume resistivity and hardness.

### [Preparation Examples 5-1 to 5-5] Evaluation of ceramic plate physical properties according to sintering temperature

Based on the overall best results obtained in Preparation Example 5, which mixed alumina and aluminum nitride in a weight ratio of 75:25, ceramic plates were prepared by differently setting only sintering temperatures, as illustrated in Table 3 below (except for the composition and sintering temperature, the preparation method was the same as in Example 1).

Then, the volume resistivity and thermal conductivity of each prepared ceramic plate were measured. Specifically, a voltage of 500 V/mm was applied to the ceramic plate, and then the current was measured after 1 minute (measured under vacuum atmosphere and at room temperature) to calculate the volume resistivity. Furthermore, specimens were produced using a LFA 467 device from NETZSCH company in compliance with ASTM C0408-88R11, and then measured at room temperature to calculate the thermal conductivity. The results are illustrated in Table 4 below.

**[Table 3]**

| | Al₂O₃ : AlN (Weight Ratio) | Sintering Temperature (°C) |
|---|---|---|
| Preparation Example 5-1 | 75 : 25 | 1,500 |
| Preparation Example 5-2 | 75 : 25 | 1,550 |
| Preparation Example 5-3 | 75 : 25 | 1,630 |
| Preparation Example 5-4 | 75 : 25 | 1,650 |
| Preparation Example 5-5 | 75 : 25 | 1,700 |

**[Table 4]**

| | Volume resistivity (@ 500°C, Ω·cm) | Thermal conductivity (@ room temperature, W/m·K) | Density (g/cm³) | Hardness (Gpa) | XRD results (wt%) | | |
|---|---|---|---|---|---|---|---|
| | | | | | Al₂O₃ | AlN | AlON |
| Preparation Example 5-1 | Immeasurable | 18.1 | 3.423 | 13.2 | 74.8 | 25.2 | 0 |
| Preparation Example 5-2 | 9.9E+09 | 32.2 | 3.718 | 14.4 | 75.4 | 24.6 | 0 |
| Preparation Example 5-3 | 3.0E+10 | 35.1 | 3.755 | 14.7 | 76.1 | 23.9 | 0 |
| Preparation Example 5-4 | 4.4E+11 | 24.8 | 3.765 | 15.1 | 71.1 | 23.8 | 5.1 |
| Preparation Example 5-5 | 6.2E+11 | 19.4 | 3.775 | 16.5 | 58.2 | 17.3 | 24.5 |

| | | | | | | | |
|---|---|---|---|---|---|---|---|
| * Al₂O_{3,} AlN and AION units: wt% | | | | | | | |

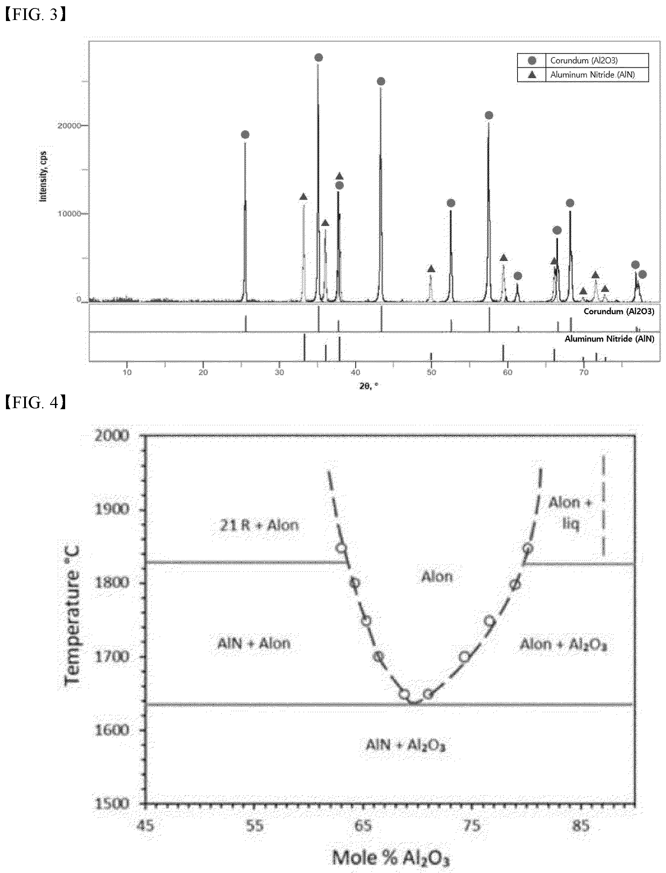

Alumina reacts with aluminum nitride at a predetermined temperature or higher to form the AlON phase. Although the AlON phase has high electrical insulation, its low thermal conductivity significantly affects the physical properties depending on the presence or absence of the formation of the AION phase. FIG. 3 is an XRD graph illustrating the physical properties of the ceramic susceptor according to sintering temperature, and FIG. 4 is a graph illustrating the correlation between alumina content and sintering temperature. Referring to FIGS. 3 and 4, at a sintering temperature of 1,500°C, non-sintering occurred, making volume resistivity measurement impossible, and thermal conductivity and density were measured to be very low. The analysis of the XRD graph revealed that the AlON phase was generated at sintering temperatures of 1,650°C or higher. As the AlON content increased, the volume resistivity increased, but thermal conductivity decreased rapidly. Therefore, it may be seen that sintering in the present invention is preferably performed at a temperature of less than 1,650°C.

### [Preparation Examples 8-19, Comparative Preparation Examples 8-19] Preparation of ceramic plates

Considering the experimental results of Preparation Example 5-3 above, raw materials were mixed according to the compositions in Table 5 below. Additionally, trace amounts of ethanol and polyvinyl butyral (binder) were mixed and dried. Next, the dried mixture was press-molded and processed to prepare a preform. Subsequently, the preform was degreased at a temperature of 500°C for 30 hours, and then the degreased preform was sintered in a high-temperature pressurized sintering furnace (250 bar pressure, 1,630°C temperature) and then polished to prepare a ceramic plate.

**[Table 5]**

| | Al₂O₃ : AlN (Weight Ratio) | Dopant | | | |
|---|---|---|---|---|---|
| | | MgO | GNP (Graphene nano powder) | Nano Y₂O₃ | Rare Earth Composite |
| Preparation Example 8 | 75 : 25 | 0.05 | | | |
| Preparation Example 9 | 75 : 25 | 0.1 | | | |
| Preparation Example 10 | 75 : 25 | 0.5 | | | |
| Preparation Example 11 | 75 : 25 | 0.1 | 0.05 | | |
| Preparation Example 12 | 75 : 25 | 0.1 | 0.1 | | |
| Preparation Example 13 | 75 : 25 | 0.1 | 0.5 | | |
| Preparation Example 14 | 75 : 25 | 0.1 | 0.1 | 0.05 | |
| Preparation Example 15 | 75 : 25 | 0.1 | 0.1 | 0.1 | |
| Preparation Example 16 | 75 : 25 | 0.1 | 0.1 | 0.5 | |
| Preparation Example 17 | 75 : 25 | 0.1 | 0.1 | 0.1 | 0.05 |
| Preparation Example 18 | 75 : 25 | 0.1 | 0.1 | 0.1 | 0.1 |
| Preparation Example 19 | 75 : 25 | 0.1 | 0.1 | 0.1 | 0.5 |
| Comparative Preparation Example 8 | 75 : 25 | 0.01 | | | |
| Comparative Preparation Example 9 | 75 : 25 | 1 | | | |
| Comparative Preparation Example 10 | 75 : 25 | 3 | | | |
| Comparative Preparation Example 11 | 75 : 25 | 0.1 | 0.01 | | |
| Comparative Preparation Example 12 | 75 : 25 | 0.1 | 1 | | |
| Comparative Preparation Example 13 | 75 : 25 | 0.1 | 3 | | |
| Comparative Preparation Example 14 | 75 : 25 | 0.1 | 0.1 | 0.01 | |
| Comparative Preparation Example 15 | 75 : 25 | 0.1 | 0.1 | 1 | |
| Comparative Preparation Example 16 | 75 : 25 | 0.1 | 0.1 | 3 | |
| Comparative Preparation Example 17 | 75 : 25 | 0.1 | 0.1 | 0.1 | 0.01 |
| Comparative Preparation Example 18 | 75 : 25 | 0.1 | 0.1 | 0.1 | 1 |
| Comparative Preparation Example 19 | 75 : 25 | 0.1 | 0.1 | 0.1 | 3 |

| | | | | | |
|---|---|---|---|---|---|
| * Dopant unit: wt% | | | | | |

### [Experimental Example 1] Evaluation of volume resistance and thermal conductivity of ceramic plates

A voltage of 500 V/mm was applied to each ceramic plate prepared from Preparation Examples 8 to 19 and Comparative Preparation Examples 8 to 19 above, and then the current was measured (measured under vacuum atmosphere and room temperature) after 1 minute to calculate the volume resistivity. The results are illustrated in Table 6 below.

Furthermore, each ceramic plate prepared from Preparation Examples 8 to 19 and Comparative Preparation Examples 8 to 19 above was produced into specimens using a LFA 467 device from NETZSCH company in compliance with ASTM C0408-88R11, and then measured at room temperature to calculate the thermal conductivity. The results are also illustrated in Table 6 below.

Furthermore, the density values of each ceramic plate prepared from Preparation Examples 8 to 19 and Comparative Preparation Examples 8 to 19 above were calculated using the Archimedes method, and the results are also illustrated in Table 6 below.

**[Table 6]**

| | Volume resistivity (@ 500°C, Ω·cm) | Thermal conductivity (@ room temperature, W/m·K) | Density (g/cm³) | Hardness (Gpa) |
|---|---|---|---|---|
| Preparation Example 8 | 4.0E+10 | 36.9 | 3.755 | 15.4 |
| Preparation Example 9 | 5.1E+10 | 37.1 | 3.751 | 15.2 |
| Preparation Example 10 | 8.3E+10 | 37.3 | 3.757 | 15.8 |
| Preparation Example 11 | 4.9E+10 | 40.2 | 3.750 | 15.4 |
| Preparation Example 12 | 4.4E+10 | 41.8 | 3.742 | 15.3 |
| Preparation Example 13 | 4.3E+10 | 42.6 | 3.707 | 15.1 |
| Preparation Example 14 | 4.5E+10 | 43.0 | 3.745 | 16.1 |
| Preparation Example 15 | 7.0E+10 | 44.4 | 3.742 | 16.3 |
| Preparation Example 16 | 8.1E+10 | 49.1 | 3.756 | 16.9 |
| Preparation Example 17 | 7.1E+10 | 45.3 | 3.751 | 16.5 |
| Preparation Example 18 | 9.5E+10 | 50.7 | 3.767 | 16.8 |
| Preparation Example 19 | 7.4E+10 | 50.2 | 3.774 | 16.5 |
| Comparative Preparation Example 8 | 3.2E+10 | 36.2 | 3.752 | 15.1 |
| Comparative Preparation Example 9 | 1.2E+11 | 24.1 | 3.761 | 16.3 |
| Comparative Preparation Example 10 | 2.7E+11 | 17.7 | 3.788 | 15.9 |
| Comparative Preparation Example 11 | 5.3E+10 | 37.2 | 3.748 | 15.3 |
| Comparative Preparation Example 12 | 2.9E+08 | 24.2 | 3.608 | 13.8 |
| Comparative Preparation Example 13 | 1.7E+07 | 18.4 | 3.489 | 11.2 |
| Comparative Preparation Example 14 | 1.4E+10 | 38.8 | 3.733 | 15.7 |
| Comparative Preparation Example 15 | 6.2E+09 | 37.0 | 3.764 | 17.2 |
| Comparative Preparation Example 16 | 8.8E+07 | 28.5 | 3.761 | 16.8 |
| Comparative Preparation Example 17 | 6.2E+10 | 39.1 | 3.732 | 16.3 |
| Comparative Preparation Example 18 | 2.8E+09 | 37.1 | 3.781 | 17.1 |
| Comparative Preparation Example 19 | 7.2E+07 | 22.9 | 3.795 | 17.1 |

As a result of measuring the volume resistivity and thermal conductivity of each ceramic plate prepared in Preparation Examples 8 to 19 and Comparative Preparation Examples 8 to 19 above, as illustrated in Table 6 above, all of the ceramic plates of Preparation Examples 8 to 19 satisfied the volume resistivity (1.0E+10 Ω·cm to 1.0E+13 Ω·cm) at 500°C required by the next-generation semiconductor manufacturing process.

In addition, in the case of thermal conductivity, as may be confirmed through the comparison of Preparation Examples 8 to 10 with Comparative Preparation Examples 8 to 10, Preparation Examples 11 to 13 with Comparative Preparation Examples 11 to 13, Preparation Examples 14 to 16 with Comparative Preparation Examples 14 to 16, and Preparation Examples 17 to 19 with Comparative Preparation Examples 17 to 19, Preparation Examples 8 to 19, which used each dopant in an amount of 0.05 to 0.5 wt%, illustrated superiority over Comparative Preparation Examples 8 to 19, which used even one dopant in an amount exceeding 0.05 to 0.5 wt%.

Meanwhile, when GNP (graphene nanopowder) was added in addition to MgO as a dopant, the effect was minimal when GNP was used in an amount of less than 0.05 wt%, and thermal conductivity was improved when GNP was used in an amount of 0.05 to 0.5 wt%. Furthermore, when GNPs were used in amounts exceeding 0.5 wt%, the volume resistivity, density, and hardness tended to decrease rapidly.

Furthermore, even when nano-sized yttria (Y₂O₃) was added as a dopant in addition to MgO and GNPs, sinterability was enhanced at 0.05 to 0.5 wt%, resulting in increased volume resistivity and thermal conductivity. However, when yttria was used in amounts exceeding 0.5 wt%, secondary phases such as YAP, YAM, and YAG formed in large quantities due to the reaction with alumina, resulting in a decrease in thermal conductivity.

Furthermore, even when rare earth composite oxides were added in addition to MgO, GNPs, and nano-Y₂O₃ as dopants, it was confirmed that the use of 0.05 to 0.5 wt% not only increased volume resistivity and thermal conductivity, but also increased density and hardness. On the other hand, when rare earth composite oxides were used in amounts exceeding 0.5 wt%, both volume resistivity and thermal conductivity tended to decrease rapidly.

Furthermore, comparing Preparation Example 9 with Comparative Preparation Example 9, Preparation Example 9 used 0.5 wt% MgO, while Comparative Preparation Example 9 used 1 wt% MgO, so that although the difference in content was not significant, the thermal conductivity decreased rapidly as the MgO content increased from 0.5 wt% to 1 wt%. This is because when the MgO content exceeds 0.5 wt%, the MgAl₂O₄ phase or MgAlON phase is generated in excess of 0.6 wt% in the final product, increasing its fraction. These results may be confirmed in Table 7 below.

**[Table 7]**

| | Al₂O₃ : AlN (Weight Ratio) | Dopant | XRD results (wt%) | | |
|---|---|---|---|---|---|
| | | MgO | Al₂O₃ | AlN | MgAl₂O₄ or MgAlON |
| Preparation Example 8 | 75 : 25 | 0.05 | 75.1 | 24.9 | 0 |
| Preparation Example 9 | 75 : 25 | 0.1 | 75.0 | 24.8 | 0.2 |
| Preparation Example 10 | 75 : 25 | 0.5 | 74.8 | 24.6 | 0.6 |
| Comparative Preparation Example 8 | 75 : 25 | 0.01 | 74.8 | 25.2 | 0 |
| Comparative Preparation Example 9 | 75 : 25 | 1 | 74.6 | 24.1 | 1.3 |
| Comparative Preparation Example 10 | 75 : 25 | 3 | 73.4 | 23.8 | 2.8 |

| | | | | | |
|---|---|---|---|---|---|
| * Dopant unit: wt% | | | | | |

### [Example 1] Preparation of ceramic susceptor

First, in the presence of Di Water (3-distilled water), alumina was supplied to a reactor of 90°C, and after 2 minutes, it was subjected to ultrasonic treatment at 60°C for 15 minutes, and then stirred for an additional 15 minutes until the temperature was raised to 90°C again. Next, urea (CO(NH₂)₂) was added to the reactor as a linker, and after 2 minutes, it was subjected to ultrasonic treatment at 60°C for 15 minutes, and then stirred for 15 minutes until the temperature was raised to 90°C again. This process was repeated a total of 4 times. Subsequently, yttria, another raw material, was additionally added to the reactor, and after 2 minutes, it was subjected to ultrasonic treatment at 60°C for 15 minutes, and then stirred for 15 minutes until the temperature was raised to 90°C again. Subsequently, a stirring process was performed for about 3 hours to synthesize the core/shell structure material. To remove unreacted residual linker and other impurities, a washing process using Di water and ethanol was performed four times. To increase the purity of the synthesized core/shell structure material, the material was dried in an oven at 80°C for 24 hours.

Meanwhile, the alumina and yttria used in the synthesis of the core/shell structure material were added to the reactor at a weight ratio of 70:30, and the linker was used in an amount of 800 parts by weight based on 100 parts by weight of yttria added (i.e., when adding the linker once, use 200 parts by weight based on 100 parts by weight of yttria added).

Subsequently, the core/shell structure material prepared as described above was crushed using a planetary ball mill for 2 hours and dispersed in ethanol to prepare a coating solution. This solution was then sprayed onto the ceramic plate prepared in Preparation Example 18 using an air sprayer.

Finally, the ceramic plate sprayed with the coating solution was sintered through hot pressing at a temperature of 1,570°C for 4 hours (post-sintering coating layer composition: 75.81 wt% alumina/24.19 wt% YAG) to prepare a ceramic susceptor with a coating layer formed on the ceramic plate, in which the shell (YAG) particle phases formed a continuous phase along the grain boundary of the core (alumina) particle phases.

### [Comparative Example 1] Preparation of conventional ceramic susceptor

A ceramic susceptor was prepared by molding and sintering alumina according to a conventional method (starting composition: 100 wt% alumina, post-sintering composition: 100 wt% alumina).

### [Comparative Example 2] Preparation of conventional ceramic susceptor

A ceramic susceptor was prepared by molding and sintering yttrium-aluminum garnet (Y₃Al₅O₁₂, YAG) according to a conventional method (starting composition: 100 wt% YAG, post-sintering composition: 100 wt% YAG).

### [Comparative Example 3] Preparation of conventional ceramic susceptor

A ceramic susceptor was prepared by molding and sintering yttria according to a conventional method (starting composition: 100 wt% yttria, post-sintering composition: 100 wt% yttria).

### [Comparative Example 4] Preparation of conventional ceramic susceptor

A ceramic susceptor containing YAG and alumina as independent phases was prepared by mechanically mixing 60 wt% alumina and 40 wt% yttria using a conventional method, and then sintering the mixture (starting composition: 60 wt% alumina/40 wt% yttria, post-sintering composition: 30.2 wt% alumina/69.8 wt% YAG).

### [Comparative Example 5] Preparation of conventional ceramic susceptor

A ceramic susceptor containing YAG and alumina as independent phases was prepared by mechanically mixing 70 wt% alumina and 30 wt% yttria using a conventional method and then sintering the mixture (starting composition: 70 wt% alumina/30 wt% yttria, post-sintering composition: 49.06 wt% alumina/50.94 wt% YAG).

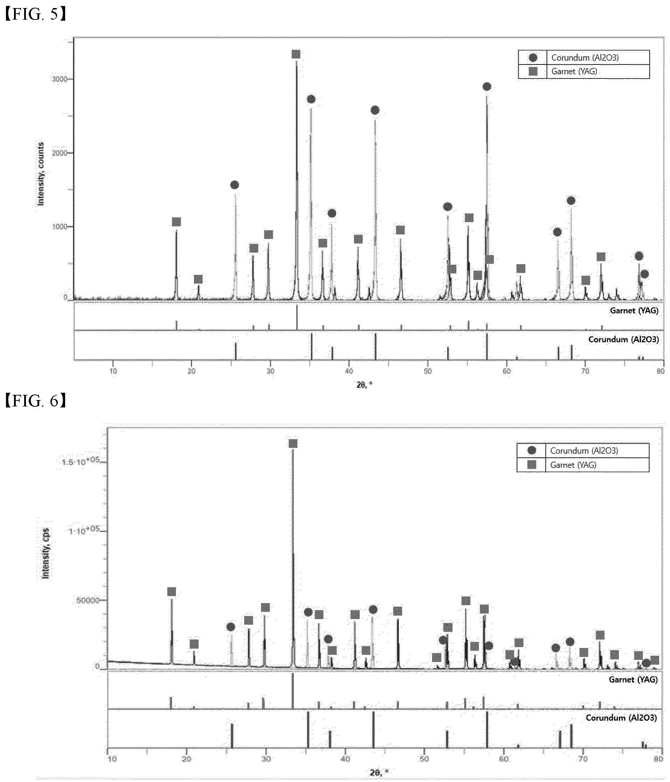

FIG. 5 is an XRD graph of the coating layer of a ceramic susceptor according to one embodiment of the present invention (specifically, corresponding to the ceramic susceptor prepared in Example 1), and FIG. 6 is an XRD graph of a conventional ceramic susceptor (specifically, corresponding to the ceramic susceptor prepared in Comparative Example 5). The results, calculated using peak values at specific 2θ angles, also confirm the composition is equivalent to the post-sintering composition.

### [Comparative Example 6] Preparation of conventional ceramic susceptor

A ceramic susceptor containing YAG and alumina as independent phases was prepared by mechanically mixing 80 wt% alumina and 20 wt% yttria according to a conventional method and then sintering the mixture (starting composition: 80 wt% alumina/20 wt% yttria, post-sintering composition: 64.91 wt% alumina/35.09 wt% YAG).

### [Comparative Example 7] Preparation of conventional ceramic susceptor

A ceramic susceptor containing YAG and alumina as independent phases was prepared by sintering after mechanically mixing 90 wt% alumina and 10 wt% yttria according to a conventional method (starting composition: 90 wt% alumina/10 wt% yttria, post-sintering composition: 82.24 wt% alumina/17.76 wt% YAG).

### [Experimental Example 2] Structural evaluation of the ceramic susceptor

As a result of examining the phase morphology of a ceramic susceptor prepared in Example 1 and Comparative Examples 1 to 7 above, as illustrated in Table 8 below, the ceramic susceptor of Example 1 above had a structure in which YAG phases forming a shell along the grain boundary of the alumina particle phases formed a continuous phase, densely bonded onto the ceramic plate layer. On the other hand, it was confirmed that Comparative Examples 1 to 3 consisted of only a single phase, and Comparative Examples 4 to 7 consisted of two phases, but were independent of each other.

**[Table 8]**

| | Phase morphology after sintering |
|---|---|
| Example 1 | A structure in which the particle phases constituting the shell form a continuous phase along the interfaces of the core particle phases, and this structure is densely bonded to the ceramic plate layer. |
| Comparative Example 1 | Single phase |
| Comparative Example 2 | Single phase |
| Comparative Example 3 | Single phase |
| Comparative Example 4 | Two phases exist independently of each other |
| Comparative Example 5 | Two phases exist independently of each other |
| Comparative Example 6 | Two phases exist independently of each other |
| Comparative Example 7 | Two phases exist independently of each other |

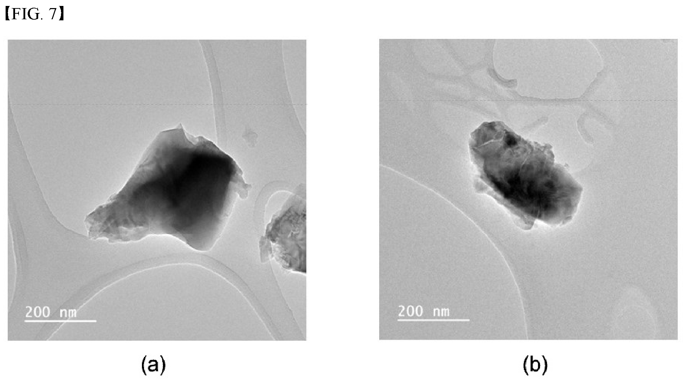

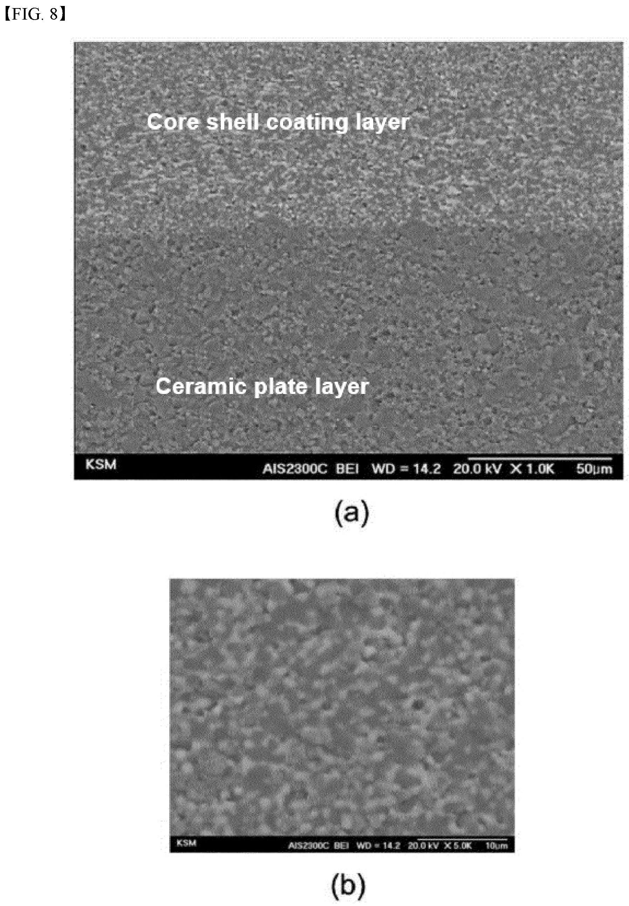

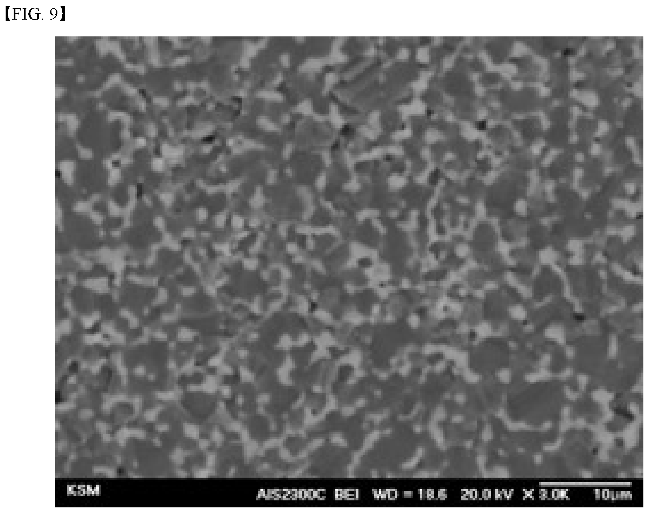

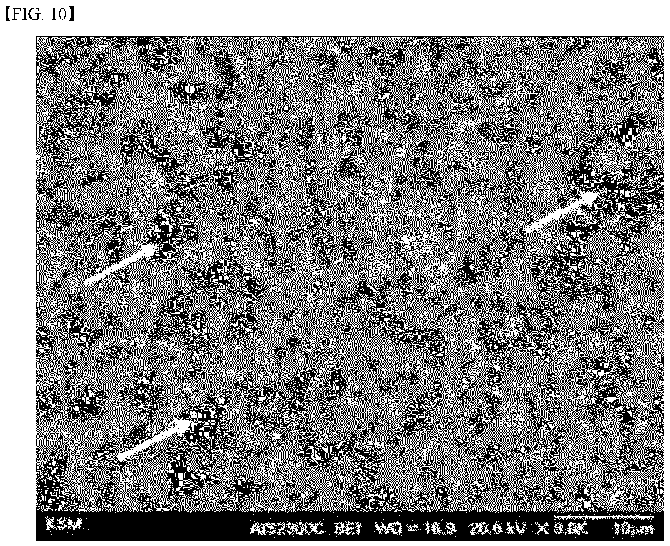

FIG. 7 is an image (FIG. 7A, FIG. 7B) of a coating layer of a ceramic susceptor according to an embodiment of the present invention observed using a transmission electron microscope (TEM), FIG. 8 is an image of a cross-section of a ceramic susceptor according to an embodiment of the present invention observed using a scanning electron microscope (SEM), FIG. 9 is an image of a cross-section of a coating layer of a ceramic susceptor according to an embodiment of the present invention observed using a scanning electron microscope (SEM), and FIG. 10 is an image of a cross-section of a conventional ceramic susceptor observed using a scanning electron microscope.

More specifically, a result of observing the ceramic susceptor prepared in Example 1 using a transmission electron microscope revealed a clear difference in contrast between the interior and exterior of the coating layer, as illustrated in FIGS. 7A and 7B. Furthermore, component analysis results confirmed that alumina was located within the interior and YAG was located within the exterior.

Next, scanning electron microscopy (SEM) observation results of the cross-sections of the ceramic susceptor prepared in Example 1 and the coating layer (FIG. 8B is an enlarged view of a portion of the "Core shell coating layer" in FIG. 8A) confirmed that the YAG particle phase formed a continuous phase along the grain boundary of the alumina particle phase, as illustrated in FIGS. 8B and 9.

On the other hand, in the case of the ceramic susceptor prepared in Comparative Example 5, as illustrated in FIG. 10, it was confirmed that although alumina and YAG particle phases are identified, they are composed of independent phases.

(For the remaining Comparative Examples 4, 6, and 7, where the sintered bodies were confirmed to contain alumina and YAG particle phases, the alumina and YAG particle phases were also confirmed to be composed of independent phases.)

### [Experimental Example 3] Evaluation of physical properties of ceramic susceptor

A voltage of 500 V/mm was applied to each of the ceramic susceptors prepared in Example 1 and Comparative Examples 1 to 7 above. After 1 minute, the current was measured (measured under vacuum atmosphere and room temperature) to calculate the volume resistivity, and the results are illustrated in Table 9 below.

Furthermore, for each of the ceramic susceptors prepared in Example 1 and Comparative Examples 1 to 7 above, specimens were produced using a LFA 467 device from NETZSCH company in compliance with ASTM C0408-88R11 and then the thermal conductivity was measured at room temperature. The results are also illustrated in Table 9 below.

In addition, the density values of each of the ceramic susceptors prepared in Example 1 and Comparative Examples 1 to 7 above were calculated using the Archimedes method, and the results are also illustrated in Table 9 below.

In addition, the etching rates of each of the ceramic susceptors prepared in Example 1 and Comparative Examples 1 to 7 above were measured (plasma resistance test), and the results are also illustrated in Table 9 below. A DektakXT Stylus Profiler (manufacturer: Bruker) was used to measure the etching rates.

In addition, the hardness of each of the ceramic susceptors prepared in Example 1 and Comparative Examples 1 to 7 above was measured, and the results are also illustrated in Table 9 below. A micro Vickers hardness tester (HM-210A, Mitutoyo company) was used for the hardness measurements, and the microhardness scale was set to HV0.5.

**[Table 9]**

| | Volume resistivity (@ 500°C, Ω·cm) | Thermal Conductivity (@ room temperature, W/m·K) | Density (g/cm³) | Etching Rate (nm/min) | Hardness (Gpa) |
|---|---|---|---|---|---|
| Example 1 | 2.1E+11 | 49.2 | 3.792 | 2.33 | 1,780 |
| Comparative Example 1 | 1.0E+11 | 23 | 3.949 | 22.8 | 1,990 |
| Comparative Example 2 | 1.5E+08 | 10 | 4.564 | 4.5 | 1,356 |
| Comparative Example 3 | 1.2E+08 | 13 | 4.671 | 2.11 | 600 |
| Comparative Example 4 | 5.7E+09 | 15 | 4.372 | - | 1,511 |
| Comparative Example 5 | 4.8E+09 | 18 | 4.271 | 8.7 | 1,622 |
| Comparative Example 6 | 2.5E+10 | 23 | 4.178 | 9.9 | 1,780 |
| Comparative Example 7 | 6.0E+11 | 30 | 4.074 | 14.9 | 1,687 |

As a result of measuring the volume resistivity and thermal conductivity of each of the ceramic susceptors prepared in Example 1 and Comparative Examples 1 to 7 above, as illustrated in Table 9 above, the ceramic susceptor of Example 1 above satisfied the levels required for electrostatic chucks and ceramic heaters in both volume resistivity and thermal conductivity.

At the same time, the ceramic susceptor of Example 1 above exhibited hardness and density sufficient to prevent or minimize corrosion and erosion characteristics, as well as particle and/or metal contamination, in the extreme environments of semiconductor processing.

Most of all, the ceramic susceptor of Example 1 above exhibited an etching rate of only 2.33 nm/min, which minimized the amount of etching byproducts and particle contamination even in harsh plasma environments, such as high-temperature and high-energy plasma. Consequently, it was confirmed that the ceramic susceptor of Example 1 above could minimize yield loss in semiconductor devices.

Meanwhile, the ceramic susceptor of Comparative Example 3 also exhibited an etching rate of only 2.11 nm/min, but its other physical properties, namely volume resistivity, thermal conductivity, and hardness, were particularly very low, making it unsuitable as a ceramic susceptor for semiconductor manufacturing equipment.

Furthermore, even if a ceramic susceptor containing a YAG phase is prepared by mixing and sintering alumina and yttria, it may be seen that simple mechanical mixing and sintering alone cannot achieve excellent plasma resistance and other physical properties beyond the standard.

According to the above, the ceramic susceptor according to the present invention satisfies the requirements of electrostatic chucks and ceramic heaters for all major physical properties (volume resistivity, thermal conductivity, density, etch rate, and hardness).

### [Experimental Example 4] Coating layer delamination test of ceramic susceptor

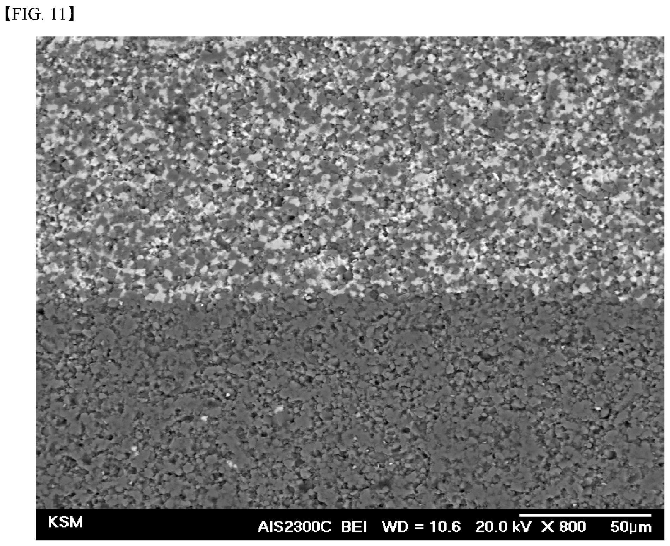

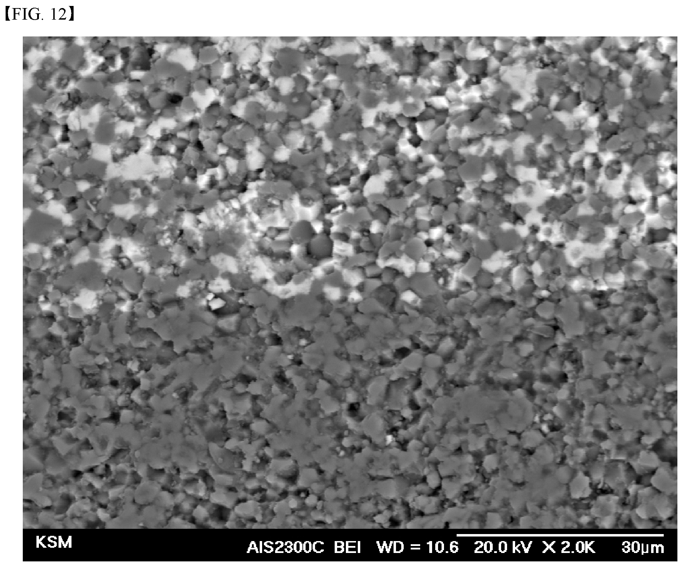

To observe coating layer delamination at high temperatures, the ceramic susceptor prepared in Example 1 above was heat treated at 500°C, the actual operating temperature, and cross-sections of the bonded surface of the ceramic plate layer and core/shell coating layer observed using a scanning electron microscope (SEM) and are illustrated in FIGS. 11 and 12 (FIG. 11: 800x magnification, FIG. 12: 2,000x magnification).

As described above, as a result of performing heat treatment at 500°C for the ceramic susceptor prepared in Example 1, and then observing a cross-section of the surface where the ceramic plate layer and the core/shell coating layer are bonded using a scanning electron microscope, as illustrated in FIGS. 11 and 12, the bonded surface between the ceramic plate layer and the core/shell coating layer maintained a dense and stable bonding structure even under a high-temperature environment, and through this, it was confirmed that the bonding strength between the ceramic plate layer and the core/shell coating layer remained the same even under high temperatures.

Therefore, it can be seen that the ceramic susceptor according to the present invention can improve plasma resistance and particle resistance without delamination of the coating layer even in a high-temperature environment such as 500°C, a temperature applied in actual semiconductor manufacturing processes.

As described above, the present invention has been described with specific details such as specific components and limited examples and drawings, but this is only provided to help a more general understanding of the present invention, and the present invention is not limited to the above-described embodiments, and those with ordinary skill in the art to which the present invention pertains may make various modifications and variations without departing from the essential characteristics of the present invention. Therefore, the spirit of the present invention should not be limited to the described embodiments, and all technical ideas that are equal or equivalent to the claims described below as well as the claims should be interpreted as being included in the scope of the rights of the present invention.

## Claims

1. A ceramic susceptor, comprising:
a ceramic plate layer; and
a coating layer positioned on the ceramic plate layer and formed by sintering a core/shell structure material,
wherein the ceramic plate layer includes alumina (Al₂O₃) and aluminum nitride (AlN) and does not include a secondary phase of an aluminum oxynitride (AlON) phase, and
the coating layer has a structure in which particle phases forming a shell form a continuous phase along the grain boundary of core particle phases.

2. The ceramic susceptor of claim 1, wherein the core grain phase includes at least one of aluminum nitride and aluminum oxide.

3. The ceramic susceptor of claim 1, wherein the continuous phase includes a plasma-resistant metal or ceramic compound selected from the group consisting of yttrium-aluminum oxide selected from the group consisting of yttrium-aluminum garnet (Y₃Al₅O₁₂, YAG), yttrium-aluminum perovskite (YAlO₃, YAP) and yttrium-aluminum monoclinic (Y₄Al₂O₉, YAM), yttrium oxide, magnesium oxide, yttria-alumina-silica (Y₂O₃-Al₂O₃-SiO₂, YAS), magnesium silicate (Mg₂SiO₄), and mullite (3Al₂O₃·2SiO₂).

4. The ceramic susceptor of claim 2, wherein the continuous phase is selected from the group consisting of yttrium-aluminum garnet (YAG, Y₃Al₅O₁₂), yttria (Y₂O₃), and magnesium oxide.

5. The ceramic susceptor of claim 4, wherein the coating layer has a structure in which yttrium-aluminum garnet (Y₃Al₅O₁₂, YAG) or magnesium aluminate spinel (MgAl₂O₄) forms the continuous phase along the grain boundary of aluminum nitride or aluminum oxide phases included in the core particle phase.

6. The ceramic susceptor of claim 5, wherein with respect to a total weight of the coating layer, a content of aluminum nitride or aluminum oxide contained in the core particle phase is 50 to 85 wt%, and a content of yttrium-aluminum garnet forming the continuous phase is 15 to 50 wt%.

7. The ceramic susceptor of claim 5, wherein with respect to a total weight of the coating layer, a content of aluminum nitride or aluminum oxide contained in the core particle phase is 50 to 90 wt%, and a content of magnesium aluminate spinel forming the continuous phase is 10 to 50 wt%.

8. The ceramic susceptor of claim 5, wherein at least one selected from the group consisting of yttria-alumina-silica (Y₂O₃-Al₂O₃-SiO₂, YAS), carbon, boron nitride, silicon carbide, scandium, and niobium is further positioned at the grain boundary between the aluminum nitride or aluminum oxide phases included on the core particle phase.

9. The ceramic susceptor of claim 1, wherein the coating layer is formed on the ceramic plate layer by hot pressing.

10. The ceramic susceptor of claim 4, wherein a reaction layer formed by reaction sintering is further formed at the grain boundary between the ceramic plate layer and the coating layer.

11. The ceramic susceptor of claim 10, wherein the continuous phase is yttrium-aluminum garnet (YAG, Y₃Al₅O₁₂) or yttria (Y₂O₃), and an yttrium-aluminum garnet (YAG, Y₃Al₅O₁₂) reaction layer is further formed at the grain boundary between the ceramic plate layer and the coating layer.

12. The ceramic susceptor of claim 10, wherein the continuous phase is magnesium oxide, and a magnesium aluminate spinel (MgAl₂O₄) reaction layer is further formed at the grain boundary between the ceramic plate layer and the coating layer.

13. The ceramic susceptor of claim 1, wherein the ceramic susceptor has a volume resistivity of 1.0E+10 to 1.0E+13 Ω·cm at 500°C and a thermal conductivity of 30 to 60 W/m·K at room temperature.
